# EUROPÄISCHE PATENTSCHRIFT

(11) **EP 4 078 302 B1**
(45) Veröffentlichungstag und Bekanntmachung des Hinweises auf die Patenterteilung: **06.11.2024**
(21) Anmeldenummer: 20824210.7
(22) Anmeldetag: 10.12.2020
(51) Int. Cl.: G05B 19/042, G05B 19/05

(54) **VORRICHTUNG ZUM SIGNALAUSTAUSCH ZWISCHEN STEUERUNG UND FELDGERÄTEN**
APPARATUS FOR SIGNAL EXCHANGE BETWEEN CONTROLLER AND FIELD DEVICES
APPAREIL D'ÉCHANGE DE SIGNAUX ENTRE UN DISPOSITIF DE COMMANDE ET DES DISPOSITIFS DE TERRAIN

(30) Priorität: 19.12.2019 DE 102019135089
(43) Veröffentlichungstag der Anmeldung: 26.10.2022
(73) Patentinhaber: PHOENIX CONTACT GmbH & Co. KG, 32825 Blomberg (DE)
(72) Erfinder: SCHAPER, Elmar, 32676 Lügde (DE); MEYER-GRÄFE, Karsten, 33758 Schloß Holte-Stukenbrock (DE); HARNASCH, Rüdiger, 33098 Paderborn (DE)
(74) Vertreter: LifeTech IP Spies & Behrndt Patentanwälte PartG mbB
(86) Internationale Anmeldenummer: PCT/EP2020/085555
(87) Internationale Veröffentlichungsnummer: WO 2021/122318

(56) Entgegenhaltungen:
- EP-A2- 1 174 781
- DE-A1- 19 512 372
- DE-C1- 19 855 869
- US-A1- 2018 341 609
- US-B2- 9 971 727

## Beschreibung

Die Erfindung betrifft eine Vorrichtung zum Signalaustausch zwischen einer Steuerung und mindestens zwei Feldgeräten.

Steuerungen, insbesondere speicherprogrammierbare Steuerungen (SPS), sind mit Logikmodulen verbindbar, um verschiedenste Signalformen feldseitig zu erfassen oder auszugeben. Dies wird auch als Signalkonditionierung oder fachsprachlich allgemeiner als "marshalling" bezeichnet. Das Dokument US 9 971 727 B2 beschreibt ein Interposer-System zum Verarbeiten von Eingabe- und/oder Ausgabe-Signalen, die zwischen einem Feldgerät und einer Steuerung übertragen werden. Das System umfasst einen Träger, auf den Module mit einer Signalverarbeitungsschaltung gesteckt werden. Der Träger umfasst sowohl einen feldseitigen Anschluss als auch einen steuerungsseitigen Anschluss.

Die Dokumente DE 195 12 372 A1 und EP 1 174 781 A2 offenbaren jeweils eine Vorrichtung zur Signalanpassung zwischen einem Automatisierungsprozess und Feldvorrichtungen.

Das Dokument DE 198 55 869 C1 offenbart eine Feldbus-Anschlussvorrichtung mit einer bodenseitig angeordneten Basisplatine in einem quaderförmigen Gehäuse. Seitliche Anschlusselemente der Basisplatine dienen einerseits einem seriellen Bussystem und zum Anschluss einer Vielzahl von Sensoren und Aktoren.

Im Dokument US 2018/341609 A1 werden weitere Einzelheiten über E/A-Module mit einer Grundplatte und einer Mehrzahl von Universalschaltungen erörtert.

Während das herkömmliche Interposer-System vorteilhaft für den Austausch der Module ist, kann die beim Austausch eines Moduls unveränderte Verdrahtung der Feldgeräte am Träger dazu führen, dass entweder eine bestehende, für die geänderte Signalform ungeeignete (beispielsweise störanfällige) Signalleitung verwendet wird oder eine erneute Konfektionierung des feldseitigen Anschlusses am Träger erforderlich ist. Das gilt entsprechende für den steuerungsseitigen Anschluss.

Somit besteht vor dem Hintergrund des Stands der Technik die Aufgabe darin, einen Träger anzugeben, bei dem einzelne Module unabhängig voneinander und im Betrieb gewechselt werden können, wobei eine vereinfachte Adaption bzw. erhöhte Variabilität in den Anschlussmöglichkeiten zur Verbindung mit Feldgeräten bzw. einer Steuerung ermöglicht ist.

Die Aufgabe wird mit den Merkmalen des unabhängigen Anspruchs gelöst. Zweckmäßige Ausgestaltungen und vorteilhafte Weiterbildungen der Erfindung sind in den abhängigen Ansprüchen angegeben.

Ausführungsbeispiele der Erfindung sind im Folgenden unter teilweiser Bezugnahme auf die Figuren beschrieben.

Gemäß einem ersten Aspekt umfasst eine Vorrichtung zum Signalaustausch zwischen einer Steuerung und mindestens zwei Feldgeräten einen Träger und ein oder mehrere Module. Der Träger umfasst eine Steuer-Schnittstelle und mindestens zwei Steckplätze. Die Steuer-Schnittstelle ist zum Anschluss von mindestens zwei elektrischen Leitungskanälen der Steuerung ausgebildet und die mindestens zwei Steckplätze sind jeweils zur lösbaren mechanischen Verbindung eines Moduls und Durchleitung mindestens eines der Leitungskanäle an das jeweilige Modul ausgebildet. Das Modul umfasst oder die mehreren Module umfassen jeweils eine trägerseitige Steckplatz-Schnittstelle und eine von der Steckplatz-Schnittstelle verschiedene feldseitige Ein- und/oder Ausgabeschnittstelle (EA-Schnittstelle). Die Steckplatz-Schnittstelle ist zur lösbaren mechanischen und elektrischen Verbindung mit einem der Steckplätze des Trägers ausgebildet. Die EA-Schnittstelle ist zum Anschluss von Signalleitungen eines der Feldgeräte ausgebildet.

Ausführungsbeispiele können einen Wechsel einzelner Module am Träger ermöglichen, beispielsweise unabhängig voneinander und/oder im Betrieb der Steuerung, der Vorrichtung und/oder der anderen Module. Durch den Wechsel einzelner Module, welche die von der Steckplatz-Schnittstelle verschiedene EA-Schnittstelle umfassen, können die Anschlüsse zur Verbindung mit Feldgeräten (d.h. die EA-Schnittstellen zum Anschluss der Signalleitungen der Feldgeräte) und/oder der Anschluss zur Verbindung mit der Steuerung (d.h. die Steuer-Schnittstelle zum Anschluss der Leitungskanäle) anpassbar oder variable sein, beispielsweise anpassbar in Reaktion auf einen Austausch einzelner Feldgeräte und/oder deren Verdrahtung (d.h. deren Signalleitungen).

Ausführungsbeispiele des oder der (vorzugsweise signalverarbeitenden) Module können zunächst an den Steckplätzen eines Ausführungsbeispiels des Trägers angeordnet sein. Zur Verbesserung der Anpassbarkeit oder Variabilität kann das oder können die Module jeweils wenigstens zwei Schnittstellen aufweisen, insbesondere die Steckplatz-Schnittstelle und die EA-Schnittstelle, die dazu ausgebildet sind, eine elektrische Verbindung mit der Steuerung (beispielsweise einem Controllersystem oder zentralen Leitsystem) beziehungsweise mit dem jeweiligen Feldgerät herzustellen. Beispielsweise sind am jeweiligen Modul eine Schnittstelle (nämlich die Steckplatz-Schnittstelle) zur Verbindung mit dem Steckplatz und eine weitere Schnittstelle (nämlich die EA-Schnittstelle, vorzugsweise eine Steckverbinderhälfte oder Steckeranschluss) zur Verdrahtung zum Feldgerät vorgesehen.

Die Module können dazu ausgebildet sein, sich mittels ihrer Steckplatz-Schnittstelle im Betrieb der Steuerung mit dem jeweiligen Steckplatz des Trägers elektrisch zu verbinden oder zu lösen und/oder einen Kommunikationskanal mit der Steuerung über den jeweiligen Leitungskanal der Steuerung aufzubauen oder abzubauen.

Die Steuerung kann eine (beispielsweise industrielle) Prozesssteuerung sein. Der Träger kann auch als Trägerboard oder Interposer bezeichnet werden. Die Feldgeräte können Sensoren und/oder Aktoren umfassen.

Das Anschließen und Trennen des Moduls (beispielsweise feldseitig an beziehungsweise von dem jeweiligen Feldgerät oder steuerungsseitig an bzw. von der Steuerung) kann ein Anschließen bzw. Trennen der Signalleitungen von der betreffenden EA-Schnittstelle umfassen, beispielsweise ein Verbinden bzw. Lösen eines für das jeweilige Modul vorgesehenen Steckers an der betreffenden EA-Schnittstelle (vorzugsweise eine EA-Buchse).

Ausführungsbeispiele können eine einfache Adaption des Moduls oder eines der Module auf dem Träger ermöglichen. Alternativ oder ergänzend kann ein variabler Anschluss des jeweiligen Feldgeräts an einem beliebigen Leitungskanal der Steuerung ermöglicht sein. Beispielsweise kann durch den Wechsel eines einzelnen Moduls die jeweilige EA-Schnittstelle eine für das betreffende Feldgerät spezifische Steckverbinderhälfte umfassen.

Jede hierin genannte Schnittstelle kann mittels einer Klemme oder einer Steckverbinderhälfte realisiert sein, beispielsweise einer Buchse, eines Steckers oder einer hermaphroditischen Steckverbinderhälfte. Beispielsweise kann die EA-Schnittstelle einen Steckeranschluss und/oder einen Klemmenanschluss umfassen.

Der Träger kann ein gemeinsamer für die mindestens zwei Steckplätze sein. Der Träger kann eine Rückverdrahtung (fachsprachlich auch: Backplane) zur Durchleitung des mindestens einen der Leitungskanäle an das jeweilige Modul aufweisen.

Die Steuer-Schnittstelle des Trägers kann eine Steckverbinderhälfte, vorzugsweise eine Buchse oder einen Stecker, umfassen. Die Steckverbinderhälfte der Steuer-Schnittstelle kann zum Anschluss der mindestens zwei elektrischen Leitungskanäle der Steuerung ausgebildet sein.

Alle Leitungskanäle können mittels einer einzigen Steckverbinderhälfte (vorzugsweise der Steuer-Schnittstelle) auf dem Träger anschließbar sein. Die Steckverbinderhälfte kann zur Steckverbindung mit einer komplementären Steckverbinderhälfte ausgebildet sein. Die komplementäre Steckverbinderhälfte kann die mindestens zwei Leitungskanäle mechanisch zusammenhängend umfassen.

Die EA-Schnittstelle eines oder jedes Moduls kann eine Steckverbinderhälfte, vorzugsweise eine Buchse oder einen Stecker, zum Anschluss der Signalleitungen des jeweiligen Feldgeräts umfassen.

Die Vorrichtung kann ferner die Signalleitungen mehrerer Feldgeräte umfassen.

Die Signalleitungen jeweils eines der mehreren Feldgeräte können eine (vorzugsweise mechanisch zusammenhängende) Steckverbinderhälfte umfassen. Die Steckverbinderhälfte des einen Feldgeräts kann lösbar verbunden oder verbindbar sein mit der EA-Schnittstelle des jeweiligen Moduls zum Anschluss der Signalleitungen des jeweiligen Feldgeräts.

Alternativ oder ergänzend können die Signalleitungen der mehreren Feldgeräte oder einer Teilmenge der Feldgeräte eine modulübergreifende Steckverbinderhälfte umfassen. Die modulübergreifende Steckverbinderhälfte kann (vorzugsweise gleichzeitig) lösbar verbunden oder verbindbar sein mit den EA-Schnittstellen der jeweiligen Module zum Anschluss der Signalleitungen der mehreren Feldgeräte. Die Steckplatz-Schnittstellen der jeweiligen Module können mit benachbarten Steckplätzen des Trägers mechanisch und elektrisch verbunden sein. Mit anderen Worten: Die mehreren Feldgeräte oder die Teilmenge der Feldgeräte können mit auf dem Träger (vorzugsweise unmittelbar) benachbart angeordneten Modulen verbunden sein mittels der modulübergreifenden Steckverbinderhälfte.

Die modulübergreifende Steckverbinderhälfte kann als gemeinsame Steckverbinderhälfte der mehreren Feldgeräte bezeichnet werden. Die modulübergreifende Steckverbinderhälfte kann eine schnelle Installation einer Gruppe von Feldgeräten ermöglichen. Beispielsweise können die mehreren Feldgeräte oder die Teilmenge der Feldgeräte oder die Gruppe von Feldgeräten, deren Signalleitungen die modulübergreifende Steckverbinderhälfte umfassen, eine funktionelle Gruppe bilden, beispielsweise einen Aktor und einen Sensor zur Regelung einer vom Aktor beeinflussten Regelgröße nach Maßgabe eines vom Sensor erfassten Ist-Werts der Regelgröße.

Die Vorrichtung kann ferner die Signalleitung oder Signalleitungen eines der Feldgeräte umfassen. Die Signalleitung oder Signalleitungen des einen der Feldgeräte kann eine modulübergreifende Steckverbinderhälfte umfassen, die (vorzugsweise gleichzeitig) lösbar verbunden oder verbindbar ist mit den EA-Schnittstellen von mindestens zwei Modulen zum Anschluss der Signalleitung oder Signalleitungen des einen der Feldgeräte an die mehreren Module. Die Steckplatz-Schnittstellen der mindestens zwei Module können mit benachbarten Steckplätzen des Trägers mechanisch und elektrisch verbunden sein. Mit anderen Worten: Das eine der Feldgeräte kann mit auf dem Träger (vorzugsweise unmittelbar) benachbart angeordneten Modulen verbunden sein mittels der modulübergreifenden Steckverbinderhälfte.

Die modulübergreifende Steckverbinderhälfte kann mehrere (vorzugsweise auf dem Träger benachbarte) Module übergreifen. Die gemeinsame Steckverbinderhälfte kann auch als Brücke bezeichnet werden. Die modulübergreifende Steckverbinderhälfte kann mit einer der Signalleitungen zu einem der Feldgeräte elektrisch leitend verbunden sein. Beispielsweise kann die mit der modulübergreifenden Steckverbinderhälfte elektrisch leitend verbundene Signalleitung an einem der modulübergreifenden Steckverbinderhälfte gegenüberliegenden Ende der Signalleitung einen Feldstecker umfassen, der mit dem einen Feldgerät elektrisch leitend verbunden oder verbindbar sein kann.

Indem ein Feldgerät mittels der modulübergreifenden Steckverbinderhälfte mit mehreren (beispielsweise zwei) Modulen verbunden ist, können die mehreren Module eine redundante und somit ausfallsichere Kommunikation zwischen der Steuerung und dem einen Feldgerät ermöglichen. Beispielsweise ist die Steuerung dazu ausgebildet, beim Ausfall der Kommunikation (vorzugsweise im Redundanz-Fall oder Fehler-Fall) mit dem einen Feldgerät über eines der Module die Kommunikation mit dem einen Feldgerät über das andere Modul fortzusetzen.

Die Vorrichtung kann ferner die Signalleitungen mindestens eines Feldgerätes umfassen. Die Signalleitungen des Feldgeräts können eine Steckverbinderhälfte umfassen, die lösbar verbunden oder verbindbar ist (vorzugsweise direkt) mit einer der Steuer-Schnittstellen des Trägers zum Anschluss der Signalleitungen des jeweiligen Feldgeräts.

Die Signalleitungen mindestens eines Feldgerätes können eine Steckverbinderhälfte umfassen, die mit einer der Steuer-Schnittstellen (beispielsweise einer jeden der Steuer-Schnittstellen) des Trägers zum Anschluss der Signalleitungen des jeweiligen Feldgeräts ohne Zwischenschaltung eines Moduls lösbar verbunden oder verbindbar sind. Beispielsweise kann an zumindest einem Steckplatz statt eines Moduls ein Stecker oder Adapter zum Anschluss der Signalleitungen eines der Feldgeräte angeordnet (vorzugsweise lösbar verbunden) sein.

Alle oder eine Teilmenge der EA-Schnittstellen können baugleich sein. Alternativ oder ergänzend können alle Anschlüsse oder eine Teilmenge der Anschlüsse der Signalleitungen baugleich sind.

Die EA-Schnittstelle und die Steckplatz-Schnittstelle jedes Moduls können jeweils voneinander räumlich getrennt sein. Die Schnittstellen können an unterschiedlichen Gehäuseseiten eines Gehäuses des jeweiligen Moduls vorgesehen sein, beispielsweise so dass eine der Schnittstellen an einer Gehäuseseite und eine weitere der Schnittstellen an einer anderen Gehäuseseite angeordnet sind. Die Gehäuseseite für den Anschluss (vorzugsweise Steckeranschluss) des jeweiligen Feldgeräts kann von außen (beispielsweise für Anschluss- und Trennvorgänge) zugänglich sein, wenn das Modul in den jeweiligen Steckplatz eingesteckt ist.

Die EA-Schnittstelle und die Steckplatz-Schnittstelle jedes Moduls können an verschiedenen Kanten des jeweiligen Moduls und/oder verschiedenen Seiten eines Modulgehäuses des jeweiligen Moduls angeordnet sein. Die EA-Schnittstelle und die Steckplatz-Schnittstelle können an aneinandergrenzenden oder gegenüberliegenden Seiten oder Kanten des jeweiligen Moduls angeordnet sein.

Die EA-Schnittstelle und die Steckplatz-Schnittstelle können jeweils eine Steckrichtung festlegen, in welche die Signalleitungen anschließbar beziehungsweise das Modul mechanisch verbindbar sind. Die Steckrichtung der EA-Schnittstelle und die Steckrichtung der Steckplatz-Schnittstelle können zueinander parallel oder quer, vorzugsweise zueinander senkrecht, sein.

Vorzugsweise kann die Schnittstelle des Trägers eine mechanische Schnittstelle zur Befestigung, beispielsweise Verriegelung, des jeweiligen Moduls umfassen. Alternativ oder ergänzend kann das Modulgehäuse eine mechanische Schnittstelle zur Befestigung, beispielsweise Verriegelung, des jeweiligen Moduls an dem Träger umfassen.

Der Träger kann dazu ausgebildet sein, an verschiedenen Steckplätzen verschiedene Leitungskanäle der Steuerung durchzuleiten.

Die Durchleitung der Leitungskanäle kann eine 1-zu-1-Verbindung von der Steuerung zum Modul sein. Die Durchleitung kann eine Rückverdrahtung oder sogenannte "Backplane" auf dem Träger umfassen.

Der Träger kann dazu ausgebildet sein, an jedem der Steckplätze jeweils einen der Leitungskanäle der Steuerung durchzuleiten. Der Träger kann dazu ausgebildet sein, jeweils genau einen der mindestens zwei elektrischen Leitungskanäle eineindeutig an jeweils einem der Steckplätze durchzuleiten.

Der Träger kann dazu ausgebildet sein, die Leitungskanäle ohne eine eigene Signalverarbeitung und/oder mit einem linearen Signalgang an das jeweilige Modul durchzuleiten. Der Träger kann dazu ausgebildet sein, die Leitungskanäle ohne eigene und/oder ohne nichtlineare Signalverarbeitung oder ohne eine Datenverarbeitung den einzelnen Modulen bereitstellen.

Die zum jeweiligen Modul durchgeleiteten Leitungskanäle können eine (vorzugsweise serielle und/oder digitale) Kommunikation zwischen der Steuerung und dem Modul umfassen. Der Träger kann dazu ausgebildet sein, die Kommunikation ohne eigene Signalverarbeitung und/oder eigene Datenverarbeitung an die einzelnen Module durchzuleiten.

Die Module können jeweils dazu ausgebildet sein, mit mindestens einem der Feldgeräte mittels der Signalleitungen in Signalleitungsverbindung zu stehen. Jedes Feldgerät kann über separate Signalleitungen mit einem zugeordneten Modul in Signalleitungsverbindung stehen. Die Signalleitungsverbindung kann Eingabesignal vom jeweiligen Feldgerät und/oder Ausgabesignale an das jeweilige Feldgerät umfassen. Die Signalleitung kann eine Verdrahtung zwischen der EA-Schnittstelle und dem jeweiligen Feldgerät umfassen.

Die Feldgeräte können mittels der EA-Schnittstelle am jeweiligen Modul über den Träger an der Steuerung angeschlossen sein. Die Sensoren können Messsignale, Analysesignale und/oder Alarmsignale mittels der Signalleitung an das jeweilige Modul ausgeben. Das jeweilige Modul kann die (beispielsweise gemessenen) Signale erfassen und als Daten über den betreffenden Leitungskanal an die Steuerung senden.

Alternativ oder ergänzend können die Aktoren Schalter und/oder Stellglieder umfassen. Das jeweilige Modul kann von der Steuerung über den weitergeleiteten Leitungskanal Steuersignale empfangen und entsprechende (beispielsweise Aktor-spezifische) Steuersignale über die EA-Schnittstelle an den Aktor ausgeben. Beispielsweise können die Module aufgrund der Signale der Feldgeräte Messdaten über die betreffenden Leitungskanäle an die Steuerung senden, vorzugsweise fortlaufend (beispielsweise periodisch oder in bestimmten Zeitintervallen) oder ereignisgetrieben (beispielsweise in Reaktion auf eine Abfrageanweisung der Steuerung). Alternativ oder ergänzend können die Module Steuerungsdaten für die jeweiligen Aktoren über die jeweiligen Leitungskanäle empfangen. Vorzugsweise tauschen die Module die erfassten Signale nicht unmittelbar untereinander aus, sondern senden diese an die Steuerung, beispielsweise zum Austausch der erfassten Signale auf einer Anwendungsebene oder Prozessebene der Steuerung.

Das Modul oder eines oder jedes der Module (oder die entsprechende Steckplatz-Schnittstelle) kann in einen jeden der Steckplätze des Moduls einsteckbar sein.

Die mindestens zwei Steckplätze des Trägers können dazu ausgebildet sein, mindestens zwei Module unabhängig voneinander mit dem Träger mechanisch zu verbinden und/oder zu lösen.

Die Module können in ihrem jeweiligen Steckplatz einzeln zugänglich, einzeln verbindbar (beispielsweise einzeln einsteckbar und/oder einzeln verriegelbar) und/oder einzeln lösbar sein. Beispielsweise kann jeder Steckplatz einen eigenständigen Verriegelungsmechanismus und/oder Längsführung zur lösbaren mechanischen Verbindung mit einem der Module umfassen. Alternativ oder ergänzend können die mindestens zwei Module aneinandergrenzend und/oder in benachbarte Steckplätze des Moduls einsteckbar sein. Beispielsweise können mindestens zwei Module gleichzeitig (d.h. en bloc) in ihre jeweiligen Steckplätze einsteckbar sein.

Das Modul oder zumindest eines oder jedes der Module kann eine Signalverarbeitungseinheit umfassen, die dazu ausgebildet ist, Signale an der EA-Schnittstelle auszugeben und/oder zu erfassen, Signale an der Steckplatz-Schnittstelle zu empfangen beziehungsweise zu senden, und die empfangenen Signale zu den ausgegebenen Signalen zu verarbeiten beziehungsweise die erfassten Signale zu den gesendeten Signalen zu verarbeiten.

Das Modul oder jedes der Module kann eine elektronische Signalverarbeitungseinheit umfassen, die (beispielsweise in der Automatisierung oder der Produktionstechnik) mittels der Steckplatz-Schnittstelle, der Durchleitung des betreffenden Leitungskanals und über die Steuer-Schnittstelle an die Steuerung angeschlossen oder anschließbar ist. Die Module können dazu ausgebildet sein, Funktionen auf einer Feldebene, auf einer physikalischen Ebene und/oder auf der untersten Ebene in einem Protokollstapel oder hierarchischen Ebenenmodell (z.B. im OSI-Layer-Modell) eines Feldbusses (beispielsweise in der Automatisierung oder der Produktionstechnik) bereitzustellen.

Die Signalverarbeitungseinheit kann einen Signalverstärker, einen Analog-Digital-Wandler, einen Digital-Analog-Wandler, eine galvanische Trennung (beispielsweise einen Optokoppler) und/oder ein Festkörperrelais (beispielsweise zum Schalten eines Stromkreises nach Maßgabe eines logischen Steuersignals von der Steuerung) umfassen.

Das oder jedes Modul kann ein eigenes Modulgehäuse umfassen. Vorzugsweise kann in dem jeweiligen Modulgehäuse die jeweilige Signalverarbeitungseinheit angeordnet und/oder implementiert sein.

Die Vorrichtung kann ferner ein Vorrichtungsgehäuse umfassen. Im Vorrichtungsgehäuse kann der Träger angeordnet und das oder die Module im mit dem Träger verbundenen Zustand angeordnet oder anordenbar sein. Optional kann die EA-Schnittstelle durch eine Öffnung im Vorrichtungsgehäuse von außerhalb des Vorrichtungsgehäuses zugänglich sein im mit dem Träger verbundenen Zustand des jeweiligen Moduls.

Nachfolgend wird die Erfindung unter Bezugnahme auf die Zeichnungen anhand bevorzugter Ausführungsbeispiele näher erläutert.

Es zeigen:
- Fig. 1: eine schematische perspektivische Ansicht einer Vorrichtung zum Signalaustausch zwischen einer Steuerung und mindestens zwei Feldgeräten gemäß einem ersten Ausführungsbeispiel;
- Fig. 2: eine schematische perspektivische Ansicht einer Vorrichtung zum Signalaustausch zwischen einer Steuerung und mindestens zwei Feldgeräten gemäß einem zweiten Ausführungsbeispiel;
- Fig. 3: eine schematische perspektivische Ansicht einer Vorrichtung zum Signalaustausch zwischen einer Steuerung und mindestens zwei Feldgeräten gemäß einem zweiten Ausführungsbeispiel; und
- Fig. 4: eine schematische perspektivische Ansicht einer Vorrichtung zum Signalaustausch zwischen einer Steuerung und mindestens zwei Feldgeräten gemäß einem zweiten Ausführungsbeispiel.

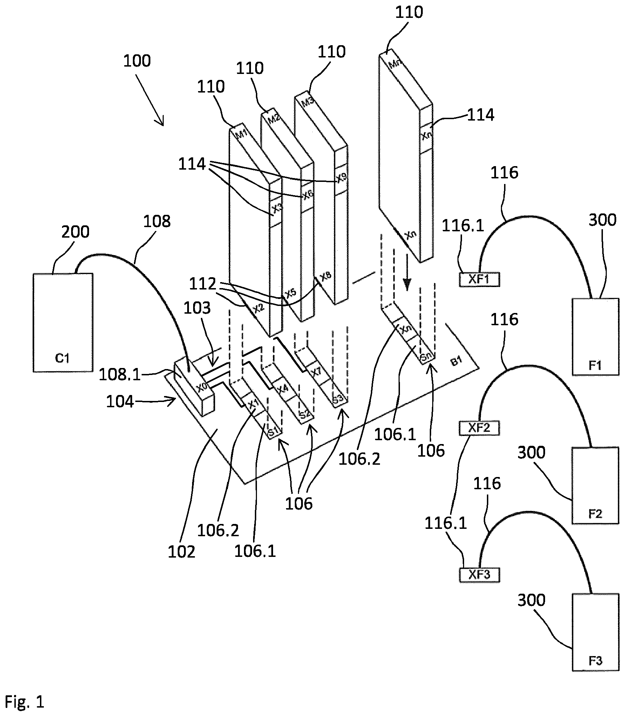

Die Fig. 1 zeigt eine schematische perspektivische Ansicht eines ersten Ausführungsbeispiels einer allgemein mit Bezugszeichen 100 bezeichneten Vorrichtung zum Signalaustausch zwischen einer Steuerung und mindestens zwei Feldgeräten. Die Vorrichtung 100 umfasst einen Träger 102, der eine Steuer-Schnittstelle 104 und mindestens zwei Steckplätze 106 umfasst. Die Steuer-Schnittstelle 104 ist zum Anschluss 108.1 von mindestens zwei elektrischen Leitungskanälen 108 der Steuerung 200 ausgebildet. Die mindestens zwei Steckplätze 106 sind jeweils zur lösbaren mechanischen Verbindung 106.1 eines Moduls 110 und zur Durchleitung 106.2 mindestens eines der Leitungskanäle 108 an das jeweilige Modul 110 ausgebildet.

Ferner umfasst die Vorrichtung 100 ein oder mehrere Module 110, die jeweils eine trägerseitige Steckplatz-Schnittstelle 112 und eine von der Steckplatz-Schnittstelle 112 verschiedene feldseitige Ein- und/oder Ausgabeschnittstelle 114 (EA-Schnittstelle, auch E/A-Schnittstelle oder fachsprachlich "I/O-Interface") umfassen. Die Steckplatz-Schnittstelle 112 ist zur lösbaren mechanischen und elektrischen Verbindung mit einem der Steckplätze 106 des Trägers 102 ausgebildet. Die EA-Schnittstelle 114 ist zum Anschluss 116.1 von Signalleitungen 116 eines der Feldgeräte 300 ausgebildet.

Der Träger 102 kann auch fachsprachlich als Trägerboard oder Motherboard bezeichnet werden oder in den Figuren mit "B1" bezeichnet sein. Die Steuerung 200 kann ein Mikrokontroller oder eine speicherprogrammierbare Steuerung (SPS) sein. Die Steuerung 200 kann in den Figuren mit "C1" bezeichnet sein. Jedes Feldgerät 300 kann mindestens einen Sensor und/oder mindestens einen Aktuator umfassen. Die Feldgeräte 300 können in den Figuren mit "F*j*" für das *j-*te Feldgerät 300 bezeichnet sein. Die Feldgeräte 300 können kollektiv als Feld bezeichnet werden.

Ein Modul "M1" der Module 110 wird auf den mit "S1" bezeichneten Steckplatz 106 gesteckt. Der Steckplatz 106 für das Modul "M1" umfasst eine mechanische Kontaktfläche, die zur (vorzugsweise zerstörungsfrei) lösbaren mechanischen Verbindung 106.1 mit dem jeweiligen Modul 110 ausgebildet ist. Beispielsweise umfasst der Steckplatz 106 ein senkrecht zu einer Ebene des Trägers 102 stehende Führung (vorzugsweise an Ecken der Kontaktfläche "S1") zur Längsführung des Moduls 110 und/oder eine Verriegelung zur lösbaren Befestigung des Moduls 110.

Auf der mechanischen Kontaktfläche "S1" oder innerhalb der Kontaktfläche "S1" ist eine trägerseitige Steckverbinderhälfte "X1" zur Durchleitung mindestens eines der Leitungskanäle 108 an das "M1" bezeichnete Modul 110.

Das "M1" bezeichnete Modul 110 umfasst an der Steckplatz-Schnittstelle 112 eine modulseitige Steckverbinderhälfte "X2". Die modulseitige Steckverbinderhälfte "X2" ist dazu ausgebildet, die trägerseitige Steckverbinderhälfte "X1" zur Durchleitung 106.2 zu kontaktieren, wenn das jeweilige Modul 110 im entsprechenden mit "S1" bezeichneten Steckplatz 106 mechanisch befestigt ist.

Vorzugsweise ist die Steckplatz-Schnittstelle 112 an einer ersten Kante oder an einer ersten Seite des Moduls 110 angeordnet, und die feldseitige EA-Schnittstelle 114 ist an einer von der ersten Kante oder ersten Seite verschiedenen zweiten Kante oder zweiten Seite desselben Moduls 110 angeordnet. Beispielsweise sind die erste Kante und die zweite Kante bzw. die erste und die zweite Seite gegenüberliegend am Modul 110. Alternativ oder ergänzend haben die erste Kante und die zweite Kante bzw. die erste und die zweite Seite eine Ecke des Moduls 110 gemeinsam, treffen sich an einer Ecke des Moduls 110 oder grenzen aneinander.

Die trägerseitige Steckplatz-Schnittstelle 112 kann auch als Trägeranschluss bezeichnet werden. Die feldseitige EA-Schnittstelle 114 kann auch als Feldanschluss bezeichnet werden. Die feldseitige EA-Schnittstelle 114 kann eine Buchse umfassen (auch: Feldbuchse).

Am "M1" bezeichneten Modul 110 ist die feldseitige EA-Schnittstelle 114 mit "X3" bezeichnet. An die feldseitige EA-Schnittstelle 114 kann ein (beispielsweise mit XF1 bezeichneter) Anschluss 116.1 des jeweiligen (beispielsweise mit F1 bezeichnete) Feldgeräts 300 angeschlossen (beispielsweise auf die EA-Schnittstelle 114 gesteckt) werden. Das Feldgerät 300 kann ein Sensor oder Aktor sein.

Der Anschluss 116.1 der Signalleitungen 116 des jeweiligen Feldgeräts 300 kann einen Stecker umfassen. Der Anschluss 116.1 der Signalleitungen 116 des jeweiligen Feldgeräts 300 kann als Feldstecker bezeichnet werden.

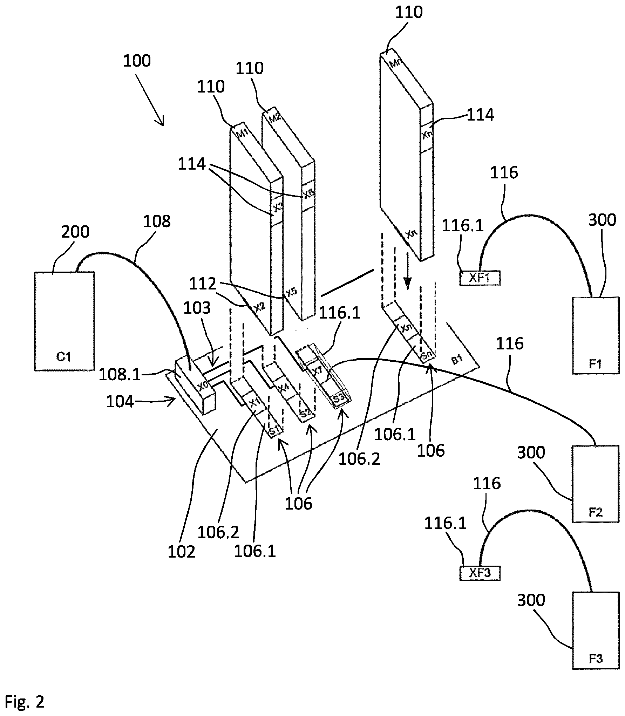

Vorzugsweise sind alle EA-Schnittstellen 114 (beispielsweise alle Feldbuchsen und/oder alle in Fig. 1 oder 2 mit "X3", "X6", "X9" etc. bezeichneten EA-Schnittstellen 114) bzw. alle Anschlüsse 116.1 (beispielsweise alle Feldstecker und/oder alle in Fig. 1 mit "XF1" bis "XF3" bezeichneten Anschlüsse) baugleich. In einem Fehler-Fall oder einem Redundanz-Fall kann ein Anschluss 116.1 (beispielsweise der Anschluss "XF1") auch auf die EA-Schnittstelle 114 eines anderen Moduls 110 gesteckt werden.

Die Steuerung 200 ist dazu ausgebildet, insbesondere im Fehler-Fall und/oder im Redundanz-Fall, die entsprechenden zwei oder mehr Module, die jeweils mit demselben Feldgerät 300 verbunden sind, jeweils (beispielsweise doppelt) auszulesen bzw. zu beschreiben.

Ausführungsbeispiel der Vorrichtung ermöglichen die variable Adaptierung im Servicefall, wodurch ein anderer Kanal als der ursprünglich genutzte gewählt werden kann. Bei doppelter Auslegung und gleichen Funktionsbausteinen (z.B. für einen digitalen Ausgang "DO") von zwei oder mehr Modulen 110 kann bei Ausfall eines Ausgangs durch Umstecken des Steckers XFj die Funktionsfähigkeit mit einem anderen Ausgang eines anderen Moduls 110 erreicht werden.

Ferner ist es möglich, dass die Steuerung 200 dazu ausgebildet ist, zwei verschiedene Programmablauffunktionen auf z.B. 2 digitale Ausgänge (DO1 und DO2) zu programmieren und/oder zu steuern. Je nach Notwendigkeit kann dann durch Umstecken der Stecker von DO1 auf DO2 diese entsprechende andere Funktion für den Aktor bereitgestellt werden.

Des Weiteren ist es möglich, ein Modul 110 weitergehend modular auszugestalten, indem signalverarbeitende und/oder leitende Bausteine zwischen der Steckplatz-Schnittstelle 112 und der EA-Schnittstelle 114 eingesetzt werden.

Bei Ausführungsbeispielen der Vorrichtung 100 müssen nicht alle Feldgeräte 300 über gesteckte Module 110 mit der Steuerung 200 verbunden sein. Beispielsweise kann der zentrale Anschluss X1 für die Durchleitung 106.2 am Steckplatz 106 genutzt werden, um darauf direkt den Feldstecker 116.1 (z.B. XF1) zu kontaktieren. Dadurch lässt sich ein Hardwareaufwand minimieren. Das kann bei einfachen Applikationen ohne zusätzliche galvanische Trennung und/oder bei kleinen Signalen, die beispielsweise direkt aus der Steuerung erzeugbar sind, erfolgen

Fig. 2 zeigt schematisch eine perspektivische Ansicht eines zweiten Ausführungsbeispiels der Vorrichtung 100. Das zweite Ausführungsbeispiel kann für sich oder in Weiterbildung des ersten Ausführungsbeispiels realisierbar sein.

Für den Fall das keine Signalverarbeitung (beispielsweise keine Signalwandlung) notwendig ist, kann auf das entsprechende Module 110 (z.B. das Modul "M1" oder, im Beispiel der Fig. 2, das Modul "M3") verzichtet werden. In dem Fall kann das entsprechende Feldgerät 300 (beispielsweise der Sensor und/oder der Aktor) mit seinem Anschluss 116.1 (beispielsweise mit dem Stecker XF1 bzw. XF3) direkt auf den Träger 102, z.B. auf den entsprechenden Steckplatz (beispielsweise den Steckplatz "S1" bzw. "S3") auf X1 gesteckt werden.

Vorzugsweise sind alle EA-Schnittstellen 114 (beispielsweise alle Feldbuchsen und/oder alle in Fig. 1 oder 2 mit "X3", "X6", "X9" etc. bezeichneten EA-Schnittstellen 114) und alle Steckplätze 106 hinsichtlich ihrer Kontaktierung zur Durchleitung 106.2 (beispielsweise die Steckverbinderhälften "X1", "X4", "X7" etc.) baugleich, beispielsweise sodass der Anschluss 116.1 wahlweise mit einem der Module 110 oder einem der Steckplätze 106 elektrisch verbindbar ist.

Die Module 110 können signalverarbeitende Module sein. Die Module 110 werden, beispielsweise soweit für die Signalverarbeitung notwendig, zunächst an Steckplätzen eines Trägers angeordnet.

In jedem Ausführungsbeispiel kann zur Erhöhung der Variabilität vorgesehen sein, dass mindestens ein Modul 110, vorzugsweise jedes Modul 110, wenigstens zwei Schnittstellen 112 und 114 aufweist, um eine Verbindung mit einer Steuerung 200 (beispielsweise einem Controllersystem) bzw. mit dem jeweiligen Feldgerät 300 herzustellen. Dabei sind eine Steckplatz-Schnittstelle 112 zur Verbindung mit dem Steckplatz 106 und eine weitere EA-Schnittstelle 114 für einen Anschluss 116.1 (beispielsweise einen Steckeranschluss) für die Signalleitungen 116 (beispielsweise zur Verdrahtung) zum Feldgerät 300 vorgesehen.

Jedes Modul 110 kann in ein Gehäuse eingefasst sein. Die Schnittstellen 112 und 114 sind vorzugsweise an unterschiedlichen Seiten des Gehäuses angeordnet, beispielsweis so dass eine Schnittstelle 112 an einer und die weitere Schnittstelle 114 an einer anderen Seite des Gehäuses angeordnet ist. Letztgenannte Seite ist vorzugsweise für den Anschluss 116.1 (beispielsweise einen Steckeranschluss) insbesondere von außen für Anschluss- und Trennvorgänge zugänglich, beispielsweise wenn das Modul in den Steckplatz 106 eingesteckt ist.

Das Anschließen und Trennen des Moduls 110 (beispielsweise feldseitig und/oder steuerungsseitig) erfolgt vorzugsweise dadurch, dass ein für das jeweilige Modul 110 vorgesehener Stecker (beispielsweise Feldstecker 116.1 bzw. trägerseitige Durchleitung 106.2) mit der betreffenden Schnittstelle 114 bzw. 112 verbunden und getrennt wird.

Ausführungsbeispiele der Vorrichtung 100 können den Vorteil bieten, dass eine einfache Adaption oder Austausch eines Moduls 110 auf einem Träger 102 ermöglicht wird. Alternativ oder darüber hinaus kann eine variable Adaptierung der Feldseite an einem beliebigen oder einem einzelnen EA-Kanal oder Leitungskanal möglich sein.

Diese offene steckbare Ausgestaltung zum Feld kann einem Kabelbaum gleichen. Eine Austauschmöglichkeit des Kabelbaums erlaubt damit eine einfache Migration und/oder Anpassbarkeit an verschiedene Erfordernisse.

Ausführungsbeispiele der Vorrichtung 100 können die EA-Schnittstelle 114 an wenigstens einem Modul 110 realisieren, während die weiteren Module beispielsweise gemäß dem Dokument US 9 971 727 an die Steuerung 200 und die Feldgeräte 300 anschließbar sein können. Damit bieten sich weitere Freiräume für eine modulare Gestaltung und individuelle Anpassbarkeit des Systems.

Jedes Ausführungsbeispiel der Vorrichtung 100 kann erweiternd eine mechanische Verbindung zwischen EA-Schnittstelle 114 und dem Anschluss 116.1 umfassen. Beispielsweise können einzelne Buchsen bzw. Stecker mit mechanischer Verbindung für mindestens eines der Module 110 vorsehen sein, die an einem Rahmen oder einem Gehäuse des jeweiligen Moduls 110 angeordnet sein können. Die mechanische Verbindung kann beispielsweise eine Verriegelung und/oder eine Schwenkvorrichtung umfassen, die dazu ausgebildet ist den Anschluss 116.1 (beispielsweise die Stecker) auf die EA-Schnittstelle 114 aufzuschwenken und/oder abzuschwenken. Dies kann die Handhabung beim Anschließen bzw. Trennen der Feldgeräte 300 vereinfachen.

Alternativ oder ergänzend kann Ausführungsbeispiel der Vorrichtung 100 erweiternd eine mechanische Verbindung zwischen Steckplatz 106 und der Steckplatz-Schnittstelle 112 umfassen. Beispielsweise können einzelne Buchsen bzw. Stecker mit mechanischer Verbindung für mindestens eines der Module 110 vorsehen sein, die an einem Rahmen oder einem Gehäuse des Trägers 102 angeordnet sein können. Die mechanische Verbindung kann beispielsweise eine Verriegelung und/oder eine Schwenkvorrichtung umfassen, die dazu ausgebildet ist das jeweilige Modul 110 (beispielsweise dessen Stecker für die Steckplatz-Schnittstelle 112) auf den Steckplatz 106 aufzuschwenken und/oder abzuschwenken. Dies kann die Handhabung beim Austausch (vorzugsweise Anschließen bzw. Trennen) der Module 110 vereinfachen.

Ferner kann der Rahmen des Trägers 102 an jedem Steckplatz 106 einen Schacht und/oder ein Fach umfassen, das dazu ausgebildet ist, jeweils eine einfachere oder geradlinige Zuführung eines Moduls 110 an den jeweiligen Steckplatz 106 des Trägers 102 zu ermöglichen.

Der Träger 102 kann eine Rückverdrahtung 103 (auch: Backplane) aufweisen zur Durchleitung zu jedem der Steckplätze 106 jeweils eines anderen oder mehrerer anderer Leitungskanäle 108 der Steuer-Schnittstelle 104.

In jedem Ausführungsbeispiel kann an der EA-Schnittstelle 114 eines oder jedes Moduls 110 eine mechanische Schnittstelle zur Befestigung des Anschlusses 116.1, beispielsweise eine Verriegelung, vorgesehen sein.

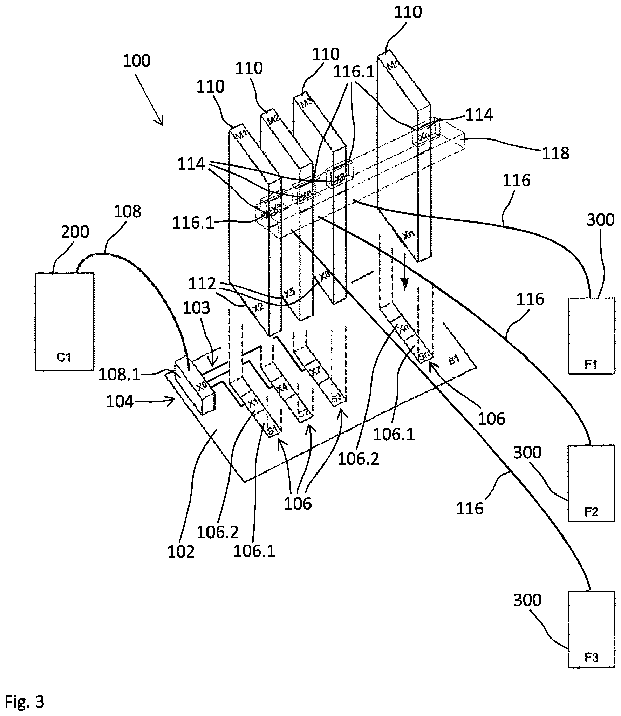

Fig. 3 zeigt schematisch eine perspektivische Ansicht eines dritten Ausführungsbeispiels der Vorrichtung 100. Das dritte Ausführungsbeispiel kann für sich oder in Weiterbildung des ersten und/oder zweiten Ausführungsbeispiels realisierbar sein.

Die Signalleitungen 116 von zwei, drei oder mehreren Feldgeräten 300 umfassen eine modulübergreifende Steckverbinderhälfte 118, vorzugsweise ein gemeinsame Steckverbinderhälfte 118 für die zwei, drei oder mehreren Feldgeräten 300. Die Steckverbinderhälfte 118 ist gleichzeitig lösbar verbunden oder verbindbar mit den EA-Schnittstellen 114 von zwei, drei bzw. mehreren Modulen 110 zum Anschluss 116.1 der Signalleitungen 116 der jeweiligen Feldgeräte 300.

Vorzugsweise sind die Steckplatz-Schnittstellen 112 der jeweiligen Module 110 mit benachbarten Steckplätzen 106 des Trägers 102 mechanisch und elektrisch verbunden. D.h. die modulübergreifende Steckverbinderhälfte 118 kann auf dem Träger 102 unmittelbar benachbarte Module übergreifen.

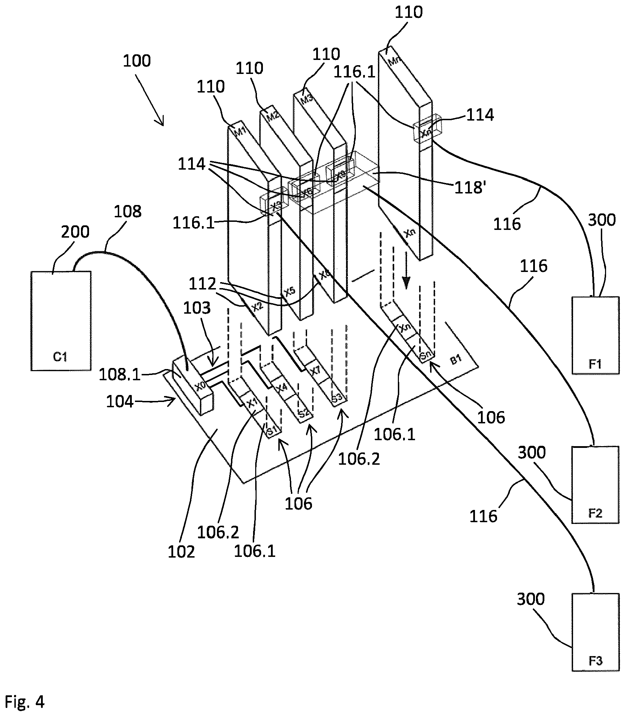

Fig. 4 zeigt schematisch eine perspektivische Ansicht eines vierten Ausführungsbeispiels der Vorrichtung 100. Das vierte Ausführungsbeispiel kann für sich oder in Weiterbildung des ersten, zweiten und/oder dritten Ausführungsbeispiels realisierbar sein.

Die Signalleitung 116 eines oder jeden Feldgeräts 300 kann eine modulübergreifende Steckverbinderhälfte 118' umfassen, die gleichzeitig lösbar verbunden oder verbindbar ist mit den EA-Schnittstellen 114 von mindestens zwei Modulen 110 zum Anschluss 116.1 der Signalleitung 116 des einen der Feldgeräte 300 an die mehreren Module 110. Dadurch kann die Redundanz, d.h. eine redundante Verdrahtung eines Feldgerätes 300 mit mindestens zwei Modulen 110 und/oder eine redundante Signalausgabe an einen Aktor 300 oder eine redundante Signalerfassung von einem Sensor 300 durch den modulübergreifende Steckverbinderhälfte 118' für vorbestimmt sein.

Im in Fig. 4 gezeigten vierten Ausführungsbeispiel sind die Signalleitungen 116 des Feldgeräts "F2" mittels der modulübergreifende Steckverbinderhälfte 118' an jeweils zwei verschiedene Module 110 angeschlossen.

Vorzugsweise sind die Steckplatz-Schnittstellen 112 der jeweiligen Module 110 mit benachbarten Steckplätzen 106 des Trägers 102 mechanisch und elektrisch verbunden. D.h. die modulübergreifende Steckverbinderhälfte 118' kann auf dem Träger 102 unmittelbar benachbarte Module übergreifen.

Obwohl die Erfindung in Bezug auf exemplarische Ausführungsbeispiele beschrieben worden ist, ist für Fachkundige ersichtlich, dass verschiedene Änderungen vorgenommen werden können und Äquivalente als Ersatz verwendet werden können. Ferner können viele Modifikationen vorgenommen werden, um eine bestimmte Situation oder ein bestimmtes Material an die Lehre der Erfindung anzupassen. Folglich ist die Erfindung nicht auf die offenbarten Ausführungsbeispiele beschränkt, sondern umfasst alle Ausführungsbeispiele, die in den Bereich der beigefügten Patentansprüche fallen.

### Bezugszeichenliste

| | |
|---|---|
| Vorrichtung | 100 |
| Träger | 102 |
| Steuer-Schnittstelle | 104 |
| Steckplatz | 106 |
| Mechanische Verbindung | 106.1 |
| Elektrische Durchleitung | 106.2 |
| Leitungskanäle | 108 |
| Anschluss der Steuerung | 108.1 |
| Modul | 110 |
| Trägerseitige Steckplatz-Schnittstelle | 112 |
| Feldseitige Ein- und/oder Ausgabeschnittstelle (EA-Schnittstelle) | 114 |
| Anschluss des Feldgeräts, vorzugsweise Feldstecker | 116.1 |
| Signalleitungen | 116 |
| Modulübergreifende Steckverbinderhälfte eines Feldgeräts | 118 |
| Modulübergreifende Steckverbinderhälfte mehrerer Feldgeräte | 118' |
| Steuerung, vorzugsweise SPS oder Mikrokontroller | 200 |
| Feldgerät, vorzugsweise Sensor und/oder Aktor | 300 |

## Patentansprüche

1. Vorrichtung (100) zum Signalaustausch zwischen einer Steuerung (200) und mindestens zwei Feldgeräten (300), umfassend:
einen Träger (102); und
ein oder mehrere Module (110),
wobei der Träger (102) eine Steuer-Schnittstelle (104) und mindestens zwei Steckplätze (106) umfasst,
**dadurch gekennzeichnet, dass**
die Steuer-Schnittstelle (104) zum Anschluss (108.1) von mindestens zwei elektrischen Leitungskanälen (108) der Steuerung (200) ausgebildet ist und die mindestens zwei Steckplätze (106) jeweils zur lösbaren mechanischen Verbindung (106.1) des oder eines der mehreren Module (110) und zur Durchleitung (106.2) mindestens eines der Leitungskanäle (108) an das jeweilige Modul (110) ausgebildet sind, und dass
das oder die mehreren Module (110) jeweils eine trägerseitige Steckplatz-Schnittstelle (112) und eine von der Steckplatz-Schnittstelle (112) verschiedene feldseitige Ein- und/oder Ausgabeschnittstelle, EA-Schnittstelle, (114) umfassen, wobei die Steckplatz-Schnittstelle (112) zur lösbaren mechanischen und elektrischen Verbindung mit einem der Steckplätze (106) des Trägers (102) ausgebildet ist, und die EA-Schnittstelle (114) zum Anschluss (116.1) von Signalleitungen (116) eines der Feldgeräte (300) ausgebildet ist.

2. Vorrichtung (100) nach Anspruch 1, wobei der Träger (102) eine Rückverdrahtung (103) zur Durchleitung (106.2) des mindestens einen der Leitungskanäle (108) an das jeweilige Modul (110) aufweist.

3. Vorrichtung (100) nach Anspruch 1 oder 2, wobei die Steuer-Schnittstelle (104) des Trägers (102) eine Steckverbinderhälfte, vorzugsweise eine Buchse, umfasst, die zum Anschluss (108.1) der mindestens zwei elektrischen Leitungskanäle (108) der Steuerung (200) ausgebildet ist.

4. Vorrichtung (100) nach einem der Ansprüche 1 bis 3, wobei die EA-Schnittstelle (114) eines oder jedes Moduls (110) eine Steckverbinderhälfte, vorzugsweise eine Buchse, zum Anschluss (116.1) der Signalleitungen (116) des jeweiligen Feldgeräts (300) umfasst.

5. Vorrichtung (100) nach einem der Ansprüche 1 bis 4, ferner die Signalleitungen (116) mehrerer Feldgeräte (300) umfassend, wobei die Signalleitungen (116) jeweils eines der mehreren Feldgeräte (300) eine Steckverbinderhälfte umfassen, die lösbar verbunden oder verbindbar ist mit der EA-Schnittstelle (114) des jeweiligen Moduls (110) zum Anschluss (116.1) der Signalleitungen (116) des jeweiligen Feldgeräts (300).

6. Vorrichtung (100) nach einem der Ansprüche 1 bis 5, ferner die Signalleitungen (116) mehrerer Feldgeräte (300) umfassend, wobei die Signalleitungen (116) der mehreren Feldgeräte (300) eine modulübergreifende Steckverbinderhälfte (118) umfassen, die gleichzeitig lösbar verbunden oder verbindbar ist mit den EA-Schnittstellen (114) der jeweiligen Module (110) zum Anschluss (116.1) der Signalleitungen (116) der mehreren Feldgeräte (300),
vorzugsweise wobei die Steckplatz-Schnittstellen (112) der jeweiligen Module (110) mit benachbarten Steckplätzen (106) des Trägers (102) mechanisch und elektrisch verbunden sind.

7. Vorrichtung (100) nach einem der Ansprüche 1 bis 6, ferner die Signalleitungen (116) eines der Feldgeräte (300) umfassend, wobei die Signalleitung (116) des einen der Feldgeräte (300) eine modulübergreifende Steckverbinderhälfte (118') umfasst, die gleichzeitig lösbar verbunden oder verbindbar ist mit den EA-Schnittstellen (114) von mindestens zwei Modulen (110) zum Anschluss (116.1) der Signalleitung (116) des einen der Feldgeräte (300) an die mehreren Module (110),
vorzugsweise wobei die Steckplatz-Schnittstellen (112) der mindestens zwei Module (110) mit benachbarten Steckplätzen (106) des Trägers (102) mechanisch und elektrisch verbunden sind.

8. Vorrichtung (100) nach einem der Ansprüche 1 bis 7, ferner die Signalleitungen (116) mindestens eines Feldgerätes (300) umfassend, wobei die Signalleitungen (116) des Feldgeräts (300) eine Steckverbinderhälfte umfassen, die lösbar verbunden oder verbindbar ist direkt mit einer der Steuer-Schnittstellen (104) des Trägers (102) zum Anschluss (116.1) der Signalleitungen (116) des jeweiligen Feldgeräts (300).

9. Vorrichtung (100) nach einem der Ansprüche 1 bis 8, wobei alle EA-Schnittstellen (114) baugleich sind und/oder alle Anschlüsse (116.1) der Signalleitungen (116) baugleich sind.

10. Vorrichtung (100) nach einem der Ansprüche 1 bis 9, wobei die EA-Schnittstelle (114) und die Steckplatz-Schnittstelle (112) jedes Moduls (110) jeweils voneinander räumlich getrennt sind.

11. Vorrichtung (100) nach einem der Ansprüche 1 bis 10, wobei die EA-Schnittstelle (114) und die Steckplatz-Schnittstelle (112) jedes Moduls (110) an verschiedenen Kanten des jeweiligen Moduls (110) und/oder verschiedenen Seiten eines Modulgehäuses des jeweiligen Moduls (110) angeordnet sind.

12. Vorrichtung (100) nach einem der Ansprüche 1 bis 11, wobei der Träger (102) dazu ausgebildet ist, an verschiedenen Steckplätzen (106) verschiedene Leitungskanäle (108) der Steuerung (200) durchzuleiten, und/oder
wobei der Träger (102) dazu ausgebildet ist, an jedem der Steckplätze (106) jeweils einen der Leitungskanäle (108) der Steuerung (200) durchzuleiten, und/oder
wobei der Träger (102) dazu ausgebildet ist, die Leitungskanäle (108) ohne eine eigene Signalverarbeitung und/oder mit einem linearen Signalgang an das jeweilige Modul durchzuleiten.

13. Vorrichtung (100) nach einem der Ansprüche 1 bis 12, wobei die mindestens zwei Steckplätze (106) des Trägers (102) dazu ausgebildet sind, mindestens zwei Module unabhängig voneinander mit dem Träger (102) mechanisch zu verbinden und/oder zu lösen.

14. Vorrichtung (100) nach einem der Ansprüche 1 bis 13, wobei das Modul (110) oder zumindest eines oder jedes der Module (110) eine Signalverarbeitungseinheit umfasst, die dazu ausgebildet ist, Signale an der EA-Schnittstelle (114) auszugeben und/oder zu erfassen, Signale an der Steckplatz-Schnittstelle (112) zu empfangen beziehungsweise zu senden, und die empfangenen Signale zu den ausgegebenen Signalen zu verarbeiten beziehungsweise die erfassten Signale zu den gesendeten Signalen zu verarbeiten.

15. Vorrichtung (100) nach einem der Ansprüche 1 bis 14, ferner ein Vorrichtungsgehäuse umfassend, in dem der Träger (102) angeordnet und das oder die Module (110) im mit dem Träger (102) verbundenen Zustand angeordnet oder anordenbar sind, optional wobei die EA-Schnittstelle (114) durch eine Öffnung im Vorrichtungsgehäuse von außerhalb des Vorrichtungsgehäuses zugänglich ist im mit dem Träger (102) verbundenen Zustand des jeweiligen Moduls (110).

## Claims

1. A device (100) for exchanging signals between a control system (200) and at least two field devices (300), comprising:
a base (102); and
a module (110) or multiple modules (110),
wherein the base (102) comprises a control interface (104) and at least two slots (106),
**characterized in that**
the control interface (104) is configured to connect (108.1) to at least two electrical line channels (108) of the control system (200), and each of the at least two slots (106) is configured to mechanically connect (106.1) detachably to the module (110) or one of the multiple modules (110) and to pass (106.2) at least one of the line channels (108) to the respective module (110); and
**in that** the module (110) or each of the multiple modules (110) comprises a base-side slot interface (112) and a field-side input and/or output interface, I/O interface (114), different from the slot interface (112), wherein the slot interface (112) is configured to mechanically and electrically connect detachably to one of the slots (106) of the base (102), and the I/O interface (114) is configured to connect (116.1) to signal lines (116) of one of the field devices (300).

2. The device (100) of claim 1, wherein the base (102) comprises a backplane (103) for passing (106.2) the at least one of the line channels (108) to the respective module (110).

3. The device (100) of claim 1 or 2, wherein the control interface (104) of the base (102) comprises a plug-in connector half, preferably a socket, configured to connect (108.1) to the at least two electrical line channels (108) of the control system (200).

4. The device (100) of any one of claims 1 to 3, wherein the I/O interface (114) of one or each module (110) comprises a plug-in connector half, preferably a socket, configured to connect (116.1) to the signal lines (116) of the respective field device (300).

5. The device (100) of any one of claims 1 to 4, further comprising the signal lines (116) of a plurality of field devices (300), wherein the signal lines (116) of each of the plurality of field devices (300) comprise a plug-in connector half that is detachably connected or connectable to the I/O interface (114) of the respective module (110) for connecting (116.1) to the signal lines (116) of the respective field device (300).

6. The device (100) of any one of claims 1 to 5, further comprising the signal lines (116) of a plurality of field devices (300), wherein the signal lines (116) of the plurality of field devices (300) comprise a modules-spanning plug-in connector half (118) that is simultaneously detachably connected or connectable to the I/O interfaces (114) of the respective modules (110) for connecting (116.1) the signal lines (116) of the plurality of field devices (300),
preferably wherein the slot interfaces (112) of the respective modules (110) are mechanically and electrically connected to adjacent slots (106) of the base (102).

7. The device (100) of any one of claims 1 to 6, further comprising the signal lines (116) of one of the field devices (300), wherein the signal lines (116) of the one of the field devices (300) comprises a modules-spanning plug-in connector half (118') that is simultaneously detachably connected or connectable to the I/O interfaces (114) of at least two modules (110) for connecting (116.1) the signal lines (116) of the one of the field devices (300) to the plurality of modules (110),
preferably wherein the slot interfaces (112) of the at least two modules (110) are mechanically and electrically connected to adjacent slots (106) of the base (102).

8. The device (100) of any one of claims 1 to 7, further comprising the signal lines (116) of at least one field device (300), wherein the signal lines (116) of the field device (300) comprise a plug-in connector half that is detachably connected or connectable directly to one of the control interfaces (104) of the base (102) for connecting (116.1) the signal lines (116) of the respective field device (300).

9. The device (100) of any one of claims 1 to 8, wherein all I/O interfaces (114) are identical in construction and/or all connections (116.1) of the signal lines (116) are identical in construction.

10. The device (100) of any one of claims 1 to 9, wherein the I/O interface (114) and the slot interface (112) of each module (110) are spatially separated from each other.

11. The device (100) according to any one of claims 1 to 10, wherein the I/O interface (114) and the slot interface (112) of each module (110) are arranged at different edges of the respective module (110) and/or different sides of a module housing of the respective module (110).

12. The device (100) of any one of claims 1 to 11, wherein the base (102) is configured to pass different line channels (108) of the control system (200) at different slots (106), and/or
wherein the base (102) is configured to pass one of the line channels (108) of the control system (200) at each of the slots (106), and/or
wherein the base (102) is configured to pass the line channels (108) to the respective module without any signal processing of its own and/or with a linear signal response.

13. The device (100) of any one of claims 1 to 12, wherein the at least two slots (106) of the base (102) are configured to mechanically connect at least two modules independently of each other to the base (102) and/or to mechanically disconnect at least two modules independently of each other from the base (102).

14. The device (100) of any one of claims 1 to 13, wherein the module (110), or at least one or each of the modules (110), comprises a signal processing unit configured to output and/or acquire signals at the I/O interface (114), to receive and/or transmit signals at the slot interface (112), and to process the received signals into the output signals and/or to process the acquired signals into the transmitted signals.

15. The device (100) of any one of claims 1 to 14, further comprising a device housing, wherein the base (102) is arranged in the device housing, and wherein the one or more modules (110) are arranged or arrangeable in the device housing in when connected to the base (102), optionally wherein the I/O interface (114) is accessible through an opening in the device housing from outside the device housing when the respective module (110) is connected to the base (102).

## Revendications

1. Dispositif (100) pour l'échange de signaux entre un système de contrôle (200) et au moins deux dispositifs de terrain (300), comprenant:
une base (102) ; et
un ou plusieurs modules (110),
la base (102) comprenant une interface de contrôle (104) et au moins deux emplacements (106),
**caractérisé en ce que**
l'interface de contrôle (104) est configurée pour une connexion (108.1) à au moins deux canaux de câblage électrique (108) du système de contrôle (200), et chacun des au moins deux emplacements (106) est configuré pour une connexion mécanique amovible (106.1) avec un de ou les plusieurs modules (110) et pour faire passer (106.2) au moins un des canaux de câblage (108) vers le module respectif (110); et
**en ce que** le module (110) ou les plusieurs modules (110) comprennent chacun une interface d'emplacement côté base (112) et une interface d'entrée et/ou de sortie côté terrain, interface E/S (114), différente de l'interface d'emplacement (112), dans laquelle l'interface d'emplacement (112) est configurée pour se connecter mécaniquement et électriquement de manière amovible avec l'un des emplacements (106) de la base (102), et l'interface E/S (114) est configurée pour une connexion (116.1) aux lignes de signaux (116) de l'un des dispositifs sur le terrain (300).

2. Dispositif (100) selon la revendication 1, dans lequel la base (102) comprend un fond de panier (103) pour faire passer (106.2) le au moins un des canaux de câblage (108) vers le module respectif (110).

3. Dispositif (100) selon la revendication 1 ou 2, dans lequel l'interface de contrôle (104) de la base (102) comprend un demi-connecteur enfichable, de préférence une prise, configuré pour se connecter (108.1) aux au moins deux canaux de câblage électrique (108) du système de contrôle (200).

4. Dispositif (100) selon l'une quelconque des revendications 1 à 3, dans lequel l'interface E/S (114) d'un ou de chaque module (110) comprend un demi-connecteur enfichable, de préférence une prise, configuré pour se connecter (116.1) aux lignes de signaux (116) du dispositif de terrain (300) respectif.

5. Dispositif (100) selon l'une quelconque des revendications 1 à 4, comprend en outre les lignes de signaux (116) d'une pluralité de dispositifs de terrain (300), les lignes de signaux (116) de chacun de la pluralité de dispositifs de terrain (300) comprenant un demi-connecteur enfichable qui est connecté de manière amovible ou connectable à l'interface E/S (114) du module respectif (110) pour se connecter (116.1) aux lignes de signaux (116) du dispositif de terrain respectif (300).

6. Dispositif (100) selon l'une quelconque des revendications 1 à 5, comprend en outre les lignes de signaux (116) d'une pluralité de dispositifs de terrain (300), dans lequel les lignes de signaux (116) de la pluralité de dispositifs de terrain (300) comprennent une moitié de connecteur enfichable (118) s'étendant sur les modules qui est simultanément connectée de manière amovible ou connectable aux interfaces E/S (114) des modules respectifs (110) pour connecter (116.1) les lignes de signaux (116) de la pluralité de dispositifs de terrain (300),
de préférence, les interfaces des emplacements (112) des modules respectifs (110) sont connectées mécaniquement et électriquement aux emplacements adjacents (106) de la base (102).

7. Dispositif (100) selon l'une quelconque des revendications 1 à 6, comprend en outre les lignes de signaux (116) de l'un des dispositifs de terrain (300), dans lequel les lignes de signaux (116) de l'un des dispositifs de terrain (300) comprennent une moitié de connecteur enfichable (118') s'étendant sur des modules qui est simultanément connectée ou connectable, de manière amovible, aux interfaces E/S (114) d'au moins deux modules (110) pour connecter (116.1) les lignes de signaux (116) de l'un des dispositifs de terrain (300) à la pluralité de modules (110),
de préférence dans lequel les interfaces des emplacements (112) des au moins deux modules (110) sont connectées mécaniquement et électriquement à des emplacements adjacents (106) de la base (102).

8. Dispositif (100) selon l'une quelconque des revendications 1 à 7, comprenant en outre les lignes de signaux (116) d'au moins un dispositif de terrain (300), dans lequel les lignes de signaux (116) du dispositif de terrain (300) comprennent un demi-connecteur enfichable qui est connecté ou connectable, de manière amovible, directement à l'une des interfaces de contrôle (104) de la base (102) pour connecter (116.1) les lignes de signaux (116) du dispositif de terrain (300) respectif.

9. Dispositif (100) selon l'une quelconque des revendications 1 à 8, dans lequel toutes les interfaces E/S (114) sont de construction identique et/ou toutes les connexions (116.1) des lignes de signaux (116) sont de construction identique.

10. Dispositif (100) selon l'une quelconque des revendications 1 à 9, dans lequel l'interface d'entrée/sortie (114) et l'interface d'emplacement (112) de chaque module (110) sont séparées spatialement l'une de l'autre.

11. Dispositif (100) selon l'une quelconque des revendications 1 à 10, dans lequel l'interface E/S (114) et l'interface d'emplacement (112) de chaque module (110) sont disposées sur des bords différents du module respectif (110) et/ou sur des côtés différents d'un boîtier de module du module respectif (110).

12. Dispositif (100) selon l'une quelconque des revendications 1 à 11, dans lequel la base (102) est configuré pour faire passer différents canaux de câblage (108) du système de contrôle (200) à différents emplacements (106), et/ou
dans lequel la base (102) est configurée pour faire passer à chaque emplacement (106) un des canaux de câblage (108) du système de contrôle (200), et/ou
dans lequel la base (102) est configuré pour faire passer les canaux de câblage (108) au module respectif sans traitement de signal propre et/ou avec une réponse de signal linéaire.

13. Dispositif (100) selon l'une quelconque des revendications 1 à 12, dans lequel les au moins deux emplacements (106) de la base (102) sont configurés pour connecter mécaniquement au moins deux modules indépendamment l'un de l'autre à la base (102) et/ou pour déconnecter mécaniquement au moins deux modules indépendamment l'un de l'autre de la base (102).

14. Dispositif (100) selon l'une des revendications 1 à 13, dans lequel le module (110), ou au moins l'un ou chacun des modules (110) comprend une unité de traitement des signaux configurée pour émettre et/ou acquérir des signaux à l'interface E/S (114), pour recevoir et/ou transmettre des signaux à l'interface d'emplacement (112), et pour traiter les signaux reçus dans les signaux d'émission et/ou pour traiter les signaux acquis dans les signaux transmis.

15. Dispositif (100) selon l'une quelconque des revendications 1 à 14, comprenant en outre un boîtier de dispositif, dans lequel la base (102) est disposée, et dans lequel le ou les modules (110) sont disposés ou peuvent être disposés dans l'état connecté avec la base (102), optionnellement l'interface E/S (114) étant accessible depuis l'extérieur du boîtier de dispositif à travers une ouverture dans le boîtier de dispositif dans l'état connecté avec la base (102) du module respectif (110).
